# EUROPEAN PATENT APPLICATION

(11) **EP 3 780 392 A1**
(43) Date of publication of application: **17.02.2021**
(21) Application number: 20190193.1
(22) Date of filing: 10.08.2020
(51) Int. Cl.: H03K 17/95, B23K 9/10, G01D 5/20, H03K 17/97, H03K 17/945

(54) **INDUCTIVE POSITION SENSOR WITH SWITCH FUNCTION**

(30) Priority: 16.08.2019 US 201916543008
(71) Applicant: Illinois Tool Works INC., Glenview, IL 60025 (US)
(72) Inventor: HOEGER, Michael V., Illinois, 60025 (US)
(74) Representative: HGF

(57) **Abstract**

An inductive sensor which includes one or more inductive coils and an inductance to digital converter. The output of the inductive sensor may be used to replace the functions of a switch and a potentiometer to initiate and control various outputs in welding-type systems and applications.

## Description

### BACKGROUND

The present disclosure relates to inductive sensors, and, more particularly, to welding systems and apparatus that incorporate inductive sensors for control purposes.

Welding is a process that has increasingly become ubiquitous in all industries. There are many different welding processes. Some welding processes and some welding equipment include user controls where the control both acts as an on/off switch and controls the output level. For example, gas tungsten arc welding ("GTAW), also known as tungsten inert gas ("TIG") welding, processes may include a foot pedal and/or a finger-tip control that controls the output of a TIG welding torch. Various on/off and output controls may be used with various welding equipment and processes.

### SUMMARY

The present disclosure relates to inductive sensors, and, more particularly, to systems and apparatus including inductive sensors for welding control purposes, substantially as illustrated by and described in connection with at least one of the figures, as set forth more completely in the claims.

### BRIEF DESCRIPTION OF THE DRAWINGS

FIG. 1a is a block diagram of an example welding system including an inductive sensor including two inductive coils, in accordance with aspects of this disclosure.
FIG. 1b is a block diagram of an example welding system including an inductive sensor including one inductive coil, in accordance with aspects of this disclosure.
FIG. 2a is an illustration of an example sensor including two inductive coils, each having a regions with varied coil spacing, and a conductive target, where the conductive target is outside the length of the coils.
FIG. 2b is an illustration of the example sensor of FIG. 2a, in which the conductive target is entering the length of the coils.
FIG. 2c is an illustration of the example sensor of FIG. 2a, in which the conductive target is at an end point along the length of the coils.
FIG. 3 is a plot of example outputs of an inductance-to-digital converter plotted against displacement of the conductive target, in which has as inputs the frequencies of the circuits including the inductive coils of FIGS. 2a-2c.
FIG. 4 is a plot of an example output of an inductance-to-digital converter of FIGS. 2a-2c for a first circuit including a first inductive coil plotted against the example output of the inductance-to-digital converter for the a second circuit including a second inductive coil.
FIG. 5 is a plot of example outputs of an inductance-to-digital converter, which has as inputs the frequencies of the circuits including the inductive coils of FIGS. 2a-2c, and which shows an effect on the inductance-to-digital converter output when the conductive target moves away from the plane which includes the coils.
FIG. 6a is a diagram of a foot pedal which includes an inductive sensor including two inductive coils which may be used to control welding-type output from a welding-type power source.
FIG. 6b is a diagram of the foot pedal of FIG. 6a in which the foot pedal has been actuated.
FIG. 7 is a diagram of an example response of an inductive circuit including one inductive coil to a position of a conductive target.
FIG. 8a is a diagram of a foot pedal which includes an inductive sensor including one inductive coil which may be used to control welding-type output from a welding-type power source.
FIG. 8b is a diagram of the foot pedal of FIG. 8a in which the foot pedal has been actuated.

The figures are not necessarily to scale. Where appropriate, similar or identical reference numerals are used to refer to similar or identical elements.

### DETAILED DESCRIPTION

In some welding applications, physically manipulable controllers are used which act as both an on/off switch for an output and control the level or magnitude of that output. For example, in TIG welding, a foot pedal may be used to both turn on and off power supplied to a TIG torch and control the magnitude of the power supplied to the torch. For example, an operator may turn power to the TIG torch on by pressing on the foot pedal to displace the foot pedal a threshold distance that initiates output power from a power source to the torch. Once the foot pedal is displaced past the threshold distance, the operator controls the magnitude of the power output to the torch by controlling the displacement of the pedal. When the operator releases the pedal back past the first threshold distance, the output from the power source is cut off to the torch. In some example TIG welding applications, a finger-tip control attached to the TIG torch may be used similarly to a foot pedal. An operator may slide a finger-tip control past a first threshold distance to initiate power from a power source to the torch. Once the finger-tip control is past the threshold distance, the operator controls the magnitude of the power output to the torch by controlling the displacement of the finger-tip control. When the operator releases the finger-tip control back past the first threshold distance, the output from the power source is cut off to the torch.

Conventionally, this type of switch and magnitude control is achieved via a combination of a potentiometer and a miniature snap-action switch. Pressing the pedal past a threshold distance causes the switch to close, and releasing the pedal back across the threshold distance causes the switch to open. When the switch closes, a signal is sent to the power source to output welding-type power to the torch. The level of power output to the torch is controlled by a potentiometer which is actuated by the movement of the foot pedal. Accordingly, once the foot pedal is displaced a threshold distance, further displacement adjusts a potentiometer which controls the power output to the torch.

In conventional switch/potentiometer control sensors, the switch should be activated in the low dead-band of the potentiometer. If the switch activates above the low dead-band of the potentiometer, then part of the useful portion of the potentiometer is wasted. Conversely, if the switch is activated too early, the switch may never open and the output will continuously remain on. These problems may be exacerbated if the switch and the potentiometer do not use the same mechanical datum. In addition to the tolerance stack up of the switch and the potentiometer, there is also mechanical tolerance stack up of the locations of the pedal which provide input for the switch and the potentiometer. A gang potentiometer or a stack of a potentiometer and a switch on the same input shaft may resolve some of these issues, but these types of potentiometers are often expensive, suffer from low cycle life, are low ingress rated, and are typically useful for power, and not signal level switching.

Disclosed example welding systems and accessories include one or more inductive sensors to provide switching and control at a substantially reduced cost and increased reliability compared to conventional devices using combinations of switches and potentiometers. In some examples, a coil with a spacing on one side of the coil that is different from a spacing on the other side of the coil produces an approximately linear flux density gradient. As used herein, the term spacing refers to the distance between successive lengths of the coil. As used herein, coil density refers to the number of loops of a coil within a given distance. This flux density gradient can be utilized to achieve the potentiometer/switch function (i.e., can be used to control on/off and the output magnitude). As a conductive target moves along the length of the coil in proximity to the coil, the resonant frequency of a resonant circuit that includes the coil changes.

In an approximately linear geometric application, two adjacent and opposing direction coils may be used to produce a phase plot in which the first coil output is plotted on the x-axis and the second coil output is plotted on the y-axis as the target moves along the lengths of the coils in proximity to the coils. The two coils manage the common-mode error in the first coil and the second coil. For example, in a situation in which only one coil is used, if the target moves away from the coil in the z-axis (i.e., the axis perpendicular to the plane of the coils), the sensor would appear to detect movement toward the lower flux density region of the coil. With two coils, however, the two coils will produce the same x-y plot shape even if the target moves in the z-axis, and control circuitry can recognize and eliminate error caused by the target moving away from the plane of the coils in the z-axis. Thus, the two coils reduce susceptibility to common-mode interference. In some examples, a single coil may be used as both a switch and a potentiometer. The coil and target may be biased such that the target does not move in the z-axis with respect to the coil.

Because the coils have a non-uniform spacing (i.e., the spacing of the coils is not consistent through the entire length of the coils), the outputs of the resonant circuits (e.g., the resonant frequency of the circuit) that include the non-uniform coils do not have monotonic responses to movement of the target relative to the coils. The coils have a densely spaced region and a sparsely spaced region. As used herein, the term monotonic means that over a given range of inputs, the corresponding output is either never decreasing or never increasing. If the target enters a coil from the densely wound region of the coil (i.e., the region where the spacing is smaller), the output of the circuit including the coil will increase rapidly and then decrease slowly after passing the point along the length of the coils where the dense region transitions to the sparse region (i.e., the point along the length of the coils where the spacing begins to increase). Conversely, if the target enters from the non-densely, or sparsely, wound region, then the output will slowly increase until reaching the point along the length of the coils where the sparse region transitions to the dense region. The specific response is dependent on the geometries of the coil(s) and the target(s). The non-monotonic region (i.e., the region that produces the sharp increase when entering from the dense region followed by a decrease) can be used as a switch. This sharp "knee" in the output curve can function as a switch, and the monotonic output after the knee functions as the potentiometer. As the same signal, the movement of the target relative to the coils, controls the switch function and the potentiometer function, the dead band issue of the conventional switch/potentiometer is eliminated. Although generally described as the target moving while the coils are stationary, in some examples the coils may move while the target is stationary and in some examples both the coils and the target may move. Relative movement between the target and the coils generates outputs from the coils as described above.

In some examples, a single coil may be used for the potentiometer and switch function, for example if the target and coil are biased such that the target and coil do not move in the z-axis with respect to each other. In a single coil example, the target may enter a coil at the less densely wound region. The target may be configured such that it is physically restricted from reaching the point on the coil where the sparse region transitions to the dense region. Therefore, as the target travels in one direction along the coil from the beginning of the coil to the restriction point, the output is monotonic (i.e., consistently not decreasing). In some examples, the point where the target enters the length of the coil may correspond to a switch function, and the remaining travelable length of the coil can be used as the potentiometer function.

Although described as a foot pedal, the inductive sensors/controllers described can be used in any sensor/controller which requires a potentiometer/switch function. For example, the inductive sensors described may be used in hand controllers, finger-tip controllers, welding gun triggers, control knobs on welding power supplies, wire feeders or welding pedants, or in any other control on the welding torch.

Disclosed example sensors include: a first coil having a spacing that increases along a length of the first coil from a first region having a first density to a second region having a second density lower than the first density; a second coil having a spacing that increases along a length of the second coil from a third region having a third density to a fourth region having a fourth density lower than the third density; a conductive target configured to travel along the length of the coils, where the first coil and the second coil are arranged such that the conductive target is adjacent the first region when the conductive target is adjacent the fourth region and the conductive target is adjacent the second region when the conductive target is adjacent the third region; and measurement circuitry configured to measure a first response of the first coil and a second response of the second coil.

In some disclosed example sensors the first coil has a first monotonic region extending from a first end of the first coil having a low-density spacing to the first dense region, and the second coil has a second monotonic region extending from a second end of the second coil having a low-density spacing to the second dense region.

In some disclosed example sensors the first monotonic region has a length greater than the length of the second coil.

In some disclosed example sensors the target is configured to travel within the first monotonic region.

In some disclosed example sensors the first response is a first inductance and the second response is a second inductance.

In some disclosed example sensors the first coil is connected to a first resonant circuit and the second coil is connected to a second resonant circuit, and the first response includes a first resonant frequency of the first resonant circuit and the second response includes a second resonant frequency of the second resonant circuit.

In some disclosed example sensors the measurement circuitry is configured to: determine a position of the target relative to the first coil based on the first response and the second response; and determine whether the second response satisfies a threshold.

In some disclosed example sensors the measurement circuitry is configured to: output a first signal indicating whether the second response satisfies the threshold, and output a second signal based on the position of the target if the second response satisfies the threshold.

In some disclosed example sensors the first coil and the second coil are formed on a first circuit board, and the target is a conductive strip printed on a second circuit board.

In some disclosed example sensors the first circuit board is a rigid printed circuit board and the second circuit board is a flexible circuit board.

In some disclosed example sensors, the second circuit board is biased to maintain a constant distance between with the first circuit board and the second circuit board as the target travels along the length of the coils.

Disclosed example mechanically actuated controllers include: a first coil having a spacing that increases along a length of the first coil from a first region having a first density to a second region having a second density lower than the first density; a second coil having a spacing that increases along a length of the second coil from a third region having a third density to a fourth region having a fourth density lower than the third density; a mechanical travel device configured to actuate a conductive target, where the conductive target is configured to travel along the length of the coils, and where the first coil and the second coil are arranged such that the conductive target is adjacent the first region when the conductive target is adjacent the fourth region and the conductive target is adjacent the second region when the conductive target is adjacent the third region; and measurement circuitry configured to measure a first response of the first coil and a second response of the second coil.

In some disclosed example mechanically actuated controllers the mechanical travel device is a foot pedal.

In some disclosed example mechanically actuated controllers the first coil has a first monotonic region extending from a first end of the first coil having a low-density spacing to the first dense region, and the second coil has a second monotonic region extending from a second end of the second coil having a low-density spacing to the second dense region.

In some disclosed example mechanically actuated controllers the first monotonic region has a length greater than the length of the second coil.

In some disclosed example mechanically actuated controllers the target is configured to travel within the first monotonic region.

In some disclosed example mechanically actuated controllers the first response is a first inductance and the second response is a second inductance.

In some disclosed example mechanically actuated controllers the first coil is connected to a first resonant circuit and the second coil is connected to a second resonant circuit, and the first response includes a first resonant frequency of the first resonant circuit and the second response includes a second resonant frequency of the second resonant circuit.

Disclosed example welding control devices include: a first coil having a spacing that increases along a length of the first coil from a first region having a first density to a second region having a second density lower than the first density; a second coil having a spacing that increases along a length of the second coil from a third region having a third density to a fourth region having a fourth density lower than the third density; a conductive target configured to travel along the length of the coils, where the first coil and the second coil are arranged such that the conductive target is adjacent the first region when the conductive target is adjacent the fourth region and the conductive target is adjacent the second region when the conductive target is adjacent the third region; and measurement circuitry configured to measure a first response of the first coil and a second response of the second coil; and communications circuitry configured to: communicate, to a welding device, an enable signal indicating whether to enable or disable a welding process based on whether the second response satisfies a threshold; and communicate, to the welding device, a control signal to control the welding process based in part on the first response and the second response if the second response satisfies the threshold.

Some disclosed example welding control devices include a mechanical travel device configured to actuate the conductive target.

Disclosed example sensors include a coil having a spacing that increases along a length of the coil from a first region having a first density to a second region having a second density lower than the first density; a conductive target configured to travel within a travel zone, the travel zone extending from a first position outside the length of the coil to a second position within the length of the coil, where the second region is adjacent the first position; and measurement circuitry configured to: measure a response of the coil to a position of the conductive target; and detect when the response satisfies a first threshold, wherein the first threshold corresponds to a position at which the conductive target enters the second region from the first position.

In some disclosed example sensors, the response of the coil to the position of the conductive target when the conductive target is between the second region and the second position is monotonic.

In some disclosed example sensors the response is an inductance.

In some disclosed example sensors the coil is connected to a resonant circuit, and wherein the response is a resonant frequency of the resonant circuit.

In some disclosed example sensors the measurement circuitry is configured to the response after determining that the response satisfied the first threshold.

In some disclosed example sensors the measurement circuitry is configured to: output a first signal indicating whether the response satisfies the first threshold; and output a second signal based on the magnitude of the response if the response satisfies the first threshold.

In some disclosed example sensors the coil is located in a first plane, the conductive target is configured to travel in a second plane, and the second plane is parallel to the first plane.

In some disclosed example sensors the coil is formed on a first circuit board, and the conductive target is a conductive strip on a second circuit board.

In some disclosed example sensors the second circuit board is biased to maintain a consistent distance between the first circuit board and the second circuit board as the conductive target travels along the length of the coil.

Disclosed example mechanically actuated controllers include: a coil having a spacing that increases along a length of the coil from a first region having a first density to a second region having a second density lower than the first density; a mechanical actuator configured to actuate a conductive target, where the conductive target is configured to travel within a travel zone, the travel zone extending from a first position outside the length of the coil to a second position within the length of the coil, and wherein the second region is adjacent the first position; and measurement circuitry configured to: measure a response of the coil to a position of the conductive target; and detect when the response satisfies a first threshold, wherein the first threshold corresponds to a position at which the conductive target enters the second region from the first position.

In some disclosed example mechanically actuated controllers the mechanical travel device is a foot pedal.

In some disclosed example mechanically actuated controllers, the response is an inductance.

In some disclosed example mechanically actuated controllers the coil is connected to a resonant circuit, and wherein the response is a resonant frequency of the resonant circuit.

In some disclosed example mechanically actuated controllers the response of the coil to the position of the conductive target when the conductive target is between the second region and the second position is monotonic.

In some disclosed example mechanically actuated controllers the measurement circuitry is configured to: output a first signal indicating whether the response satisfies the first threshold; and output a second signal based on the magnitude of the response if the response satisfies the first threshold.

In some disclosed example mechanically actuated controllers the measurement circuitry is configured to determine a position of the conductive target relative to the coil based on the response after determining that the response satisfied the first threshold.

In some disclosed example mechanically actuated controllers coil is located in a first plane, wherein the conductive target is configured to travel in a second plane, and wherein the second plane is parallel to the first plane.

In some disclosed example mechanically actuated controllers coil is formed on a first circuit board, and the conductive target is a conductive strip on a second circuit board.

In some disclosed example mechanically actuated controllers the second circuit board is biased to maintain a consistent distance between the first circuit board and the second circuit board as the conductive target travels along the length of the coil.

Disclosed example welding control devices include: a coil having a spacing that increases along a length of the coil from a first region having a first density to a second region having a second density lower than the first density; a conductive target configured to travel within a travel zone, the travel zone extending from a first position outside the length of the coil to a second position within the length of the coil, and where the second region is adjacent the first position; measurement circuitry configured to: measure a response of the coil to a position of the conductive target; and detect when the response satisfies a first threshold, wherein the first threshold corresponds to a position at which the conductive target enters the second region from the first position; and communications circuitry configured to: communicate, to a welding device, an enable signal indicating whether to enable a welding process based on whether the response satisfies the first threshold; and communicate, to the welding device, a control signal to control the welding process based on the response after detecting that response satisfies the threshold.

Welding-type power supply, welding-type power source, and welding-type system, as used herein, refers to any device capable of, when power is applied thereto, supplying welding, cladding, plasma cutting, induction heating, laser (including laser welding, laser hybrid, and laser cladding), carbon arc cutting or gouging and/or resistive preheating, including but not limited to transformer-rectifiers, inverters, converters, resonant power supplies, quasi-resonant power supplies, switch-mode power supplies, etc., as well as control circuitry and other ancillary circuitry associated therewith.

As used herein, the term "welding-type power" refers to power suitable for welding, plasma cutting, induction heating, CAC-A and/or hot wire welding/preheating (including laser welding and laser cladding).

As used herein, the term "torch" or "welding-type tool" can include a hand-held or robotic welding torch, gun, or other device used to create the welding arc.

As used herein, the term "welding mode" is the type of process or output used, such as CC, CV, pulse, MIG, TIG, spray, short circuit, etc.

Welding operation, as used herein, includes both actual welds (e.g., resulting in joining, such as welding or brazing) of two or more physical objects, an overlaying, texturing, and/or heat-treating of a physical object, and/or a cut of a physical object) and simulated or virtual welds (e.g., a visualization of a weld without a physical weld occurring).

The term "power" is used throughout this specification for convenience, but also includes related measures such as energy, current, voltage, and enthalpy. For example, controlling "power" may involve controlling voltage, current, energy, and/or enthalpy, and/or controlling based on "power" may involve controlling based on voltage, current, energy, and/or enthalpy. Electric power of the kind measured in watts as the product of voltage and current (e.g., V^{∗}I power) is referred to herein as "wattage."

As utilized herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code.

The terms "control circuit" and "control circuitry," as used herein, may include digital and/or analog circuitry, discrete and/or integrated circuitry, microprocessors, digital signal processors (DSPs), and/or other logic circuitry, and/or associated software, hardware, and/or firmware. Control circuits may include memory and a processor to execute instructions stored in memory. Control circuits or control circuitry may be located on one or more circuit boards, that form part or all of a controller, and are used to control a welding process, a device such as a power source or wire feeder, motion, automation, monitoring, air filtration, displays, and/or any other type of welding-related system.

As used, herein, the term "memory" and/or "memory device" means computer hardware or circuitry to store information for use by a processor and/or other digital device. The memory and/or memory device can be any suitable type of computer memory or any other type of electronic storage medium, such as, for example, read-only memory (ROM), random access memory (RAM), cache memory, compact disc read-only memory (CDROM), electro-optical memory, magnetooptical memory, programmable read-only memory (PROM), erasable programmable read-only memory (EPROM), electrically-erasable programmable read-only memory (EEPROM), flash memory, solid state storage, a computer-readable medium, or the like.

The present methods and/or systems may be realized in hardware, software, or a combination of hardware and software. The present methods and/or systems may be realized in a centralized fashion in at least one computing system, or in a distributed fashion where different elements are spread across several interconnected computing systems. Any kind of computing system or other apparatus adapted for carrying out the methods described herein is suited. A typical combination of hardware and software may be a general-purpose computing system with a program or other code that, when being loaded and executed, controls the computing system such that it carries out the methods described herein. Another typical implementation may comprise an application specific integrated circuit or chip. Some implementations may comprise a non-transitory machine-readable (e.g., computer readable) medium (e.g., FLASH drive, optical disk, magnetic storage disk, or the like) having stored thereon one or more lines of code executable by a machine, thereby causing the machine to perform processes as described herein.

As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations.

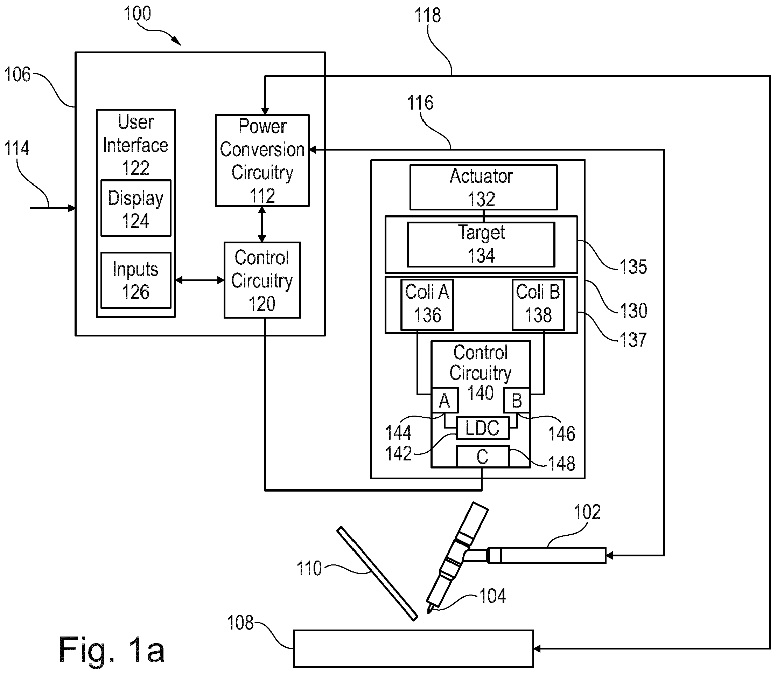

FIG. 1a is a diagram of an example gas tungsten arc welding ("GTAW") system 100. In GTAW systems such as the system 100, a metal electrode 104, typically made of tungsten, is provided in a welding torch 102, and is generally not consumed (i.e., added to the base metal) during welding. Electric current is channeled through the electrode 104 from a welding type power source 106, and a flow of an inert shielding gas surrounds the electrode 104 during the welding operation, generally provided by fluid conduits leading to the welding torch 102. An arc is struck between the electrode 104 and the workpiece 108 to melt the workpiece 108 and filler metal 110. Shielding gas prevents oxidation and other contamination of the electrode and/or the weld.

The power source 106 includes power conversion circuitry 112 configured to condition input power 114 (e.g., from the AC power grid, an engine/generator set, a combination thereof, or other alternative sources) to welding-type power. The power source 106 provides welding-type current to the torch 102 via the power delivery cable 116. The power delivery cable 116 may be included within a conduit which includes a shielding gas hose which delivers shielding gas to the torch 102. In some examples, a data cable may also be included in bundle of cables which includes the shielding gas hose and the power delivery cable 116 to enable data transfer between the torch 102 and the power source 106. In some examples, communication is enabled between the torch 102 and the power source 106 via the power delivery cable 116. For example, data (e.g., voltage measurement data at the torch 102) may be transmitted to the power source 106 via the power delivery cable 116 A ground cable 118 connects the workpiece 108 to the power source 106 to complete the weld circuit between the power source 106, the torch 102, and the workpiece 108.

Control circuitry 120 of the power source 106 controls the power output but the power conversion circuitry 112 (e.g., the voltage output, current output, pulse length, pulse shape). The power source 106 also includes a user interface 122 at which an operator may view and adjust power source 106 settings. For example, an operator may set one or more settings (e.g., welding mode, voltage output, current output, pulse length, pulse shape) via the user interface 122. In some examples, the user interface 122 is a touchscreen display. In some examples, the user interface 122 includes a display 124 and one or more physical inputs 126, such as buttons or knobs. An operator may adjust one or more settings of the power source 106 by adjusting the inputs 126. The control circuitry 120 receives and processes inputs from the user interface 122 and controls the power conversion circuitry 112 according to the received inputs.

During a typical TIG welding operation, an operator may hold the torch 102 in one hand and a filler metal rod 110 in the other hand. The operator uses a physical control device 130 (i.e., a sensor) to control the output of welding-type power from the power source 106 to the torch 102 during the welding operation. In some examples, the physical control device 130 is a foot pedal, which allows the operator to actuate the physical control device 130 (foot pedal) and thereby control the output of the power source 106 while holding the torch 102 in one hand and the filler metal rod 110 in the other hand. In some examples, the physical control device 130 may be a handheld controller. In some examples, the physical control device 130 may be included on the torch 102. For example, the physical control device 130 may be a trigger or a slidable control on the torch 102.

The physical control device 130 includes an actuator 132 which can be manipulated by an operator. If the physical control device 130 is a foot pedal, for example, the actuator is the top panel of the foot pedal which moves in a first direction (generally towards the ground or floor) when an operator applies pressure to the pedal and moves in the opposite direction (generally away from the ground or floor) when the operator releases pressure. Actuation of the actuator 132 causes movement of a conductive target 134. In some examples, the conductive target 134 may be an aluminum target. In some examples, the conductive target 134 may be a copper target. In some examples, the conductive target 134 may be a conductive target on a flexible printed circuit board 135 which is physically moved by the actuator 132. The physical control device 130 includes two inductive coils, coil A 136 and coil B 138. In some examples, coil A 136 and coil B 138 are printed onto a rigid printed circuit board 137. In some examples, the flexible printed circuit board 135 is biased to maintain a consistent distance the rigid printed circuit board 137 and the flexible printed circuit board 135. In some examples, each of coil A 136 and coil B 138 may be printed on its own rigid printed circuit board, and the flexible printed circuit board 135 is biased to maintain contact with at least one of the two rigid printed circuit boards.

The physical control device 130 includes control circuitry 140 which includes an inductance-to-digital converter 142 (i.e., measurement circuitry) and sensor circuitry A 144 and sensor circuitry B 146. Coil A 136, along with sensor circuitry A 144, encompasses a first resonator LC circuit (circuit A). Coil B 138, along with sensor circuitry B 146, encompasses a second resonator LC circuit (circuit B). The control circuitry 140 also includes communications circuitry 148 configured to communicate with the control circuitry 120 of the power source 106. In some examples, the communications circuitry 148 is a wireless interface configured to communicate with the control circuitry 120 of the power source 106 wirelessly. In some examples, the communications circuitry 148 communicates with the control circuitry 120 of the power source 106 via a wired connection.

As will be described in more detail below, the coils 136 and 138 have non-uniform coil spacing (i.e., each coil has at least one dense region and at least one region where the spacing is greater than the spacing in the dense region, which is a sparse region). As the actuator 132 is moved, the target 134 enters and moves along the lengths of the coils 136 and 138, which causes the resonant frequencies of the first resonator LC circuit (which includes coil A 136 and sensor circuitry A 144) and the second LC resonator circuit (which includes coil B 138 and sensor circuitry 146) to change. The LDC 142 detects the change in resonant frequency and provides digital outputs proportional (e.g., directly or inversely proportional) to the resonant frequencies of the LC resonator circuits. Example LDC circuits include the Texas Instruments LDC1612 2-Channel 28-bit inductance to digital converter and the Texas Instruments LDC1614 4-channel Channel 28-bit inductance to digital converter. The Texas Instruments LDC1612 and LDX1614 are described in "LDC1612, LDC1614 Multi-Channel 28-Bit Inductance to Digital Converter (LDC) for Inductive Sensing," Texas Instruments, (LDC1612, LDC1614: SNOSCY9A - December 2014-Revised March 2018), which is hereby incorporated by reference in its entirety. In some other examples, the LDC 142 may provide an output that is proportional (e.g., directly or inversely proportional) to the inductance of the coil A 136 and coil B 138. Information about LDC circuits may be found "LDC Sensor Design" by Chris Oberhauser, Texas Instruments (Application Report SNOA930A-March 2015-Revised April 2018). The entirety of "LDC Sensor Design" by Chris Oberhouser is hereby incorporated by reference. LDC circuits are also described in "LDC1612/LDC1614 Linear Position Sensing" by Ben Kasemsadeh, Texas Instruments, (Application Report: SNOA931-April 2015). The entirety of "LDC1612/LDC1614 Linear Position Sensing" by Ben Kasemsadeh is hereby incorporated by reference. Additional information about LDC circuits may be found in "LDC Target Design" by Chris Oberhauser, Texas Instruments, (Application Report: SNOA957A-September 2016-Revised May 2017). The entirety of "LDC Target Design" by Chris Oberhauser is hereby incorporated by reference.

For a non-uniformly spaced coil, the flux density gradient increases rapidly from the densely wound end of the coil to the point where the dense region transitions to a sparse region (i.e., where the coil spacing begins to increase), and then decreases more slowly from the transition point to the less dense end (sparse end) of the coil. Accordingly, the output of the LDC 142 for the resonant circuit including a non-uniformly spaced coil will increase rapidly as the target 134 enters the densely wound region until the target 134 reaches the transition point. The output of the resonant circuit will then decrease more slowly as the target 134 moves from the point of transition point towards the end of the coil having a lower coil density.

In the system 100, coil A 136 and coil B 138 are positioned adjacent each other and in opposing orientations, such that the densely wound end of coil A 136 is adjacent the sparsely wound end of coil B 138 and the densely wound end of coil B 138 is adjacent the sparsely wound end of coil A 136. Coil A 136 is positioned such that the target 134 enters from the dense end of coil A 136 and coil B 138 is positioned such that the target 134 enters from the sparse end of coil B 138. The control circuitry 140 uses the output of the LDC 142 for the resonant circuit including coil A 136 as a switch, as the output will increase rapidly when the target 134 enters the dense region of coil A 136. In other words, the control circuitry 140 sends a signal to the control circuitry 120 of the power source 106 via the communications circuitry 148 to begin outputting welding-type power when the target 134 passes a certain point on coil A 136, as determined by the respective outputs corresponding to the first resonator LC circuit and the second resonator LC circuit.

The output of the LDC 142 for the circuit including coil B 138 is monotonic (i.e., never decreasing as the target 134 moves in one direction from the sparse end to the transition point) until the point of coil B 138 where the sparse region transitions to the dense region. Accordingly, the actuator 132 and target 134 are arranged such that the target 134 is not permitted to move to the transition point of coil B 138. The output of the LDC 142 for the circuit including coil A 136 after the target 134 passes the transition point of coil A 136 and the output of the LDC 142 for the circuit including coil B 138 are used for the potentiometer function. In other words, the output of the LDC 142 for the circuit including coil A 136 after the target 134 passes the transition point of coil A 136 and the output of the LDC 142 for the circuit including coil B 138 are processed by the control circuitry 140 and sent to the control circuity 120 of the power source 106 via the communications circuitry 148 to control the welding output power level (e.g., voltage or current magnitude).

Accordingly, the physical control device 130 may function as an on/off switch and a potentiometer to both initiate and terminate welding-type power supplied by the power source 106 to the torch 102, and control the level or magnitude of power supplied by the power source 106 to the torch 102.

Although illustrated as a GTAW welding system, the physical control device 130 could be used in any welding-type application which utilizes a switch to turn on and off any type of output and a potentiometer to control the level of that output. For example, the physical control device could be used in a knob of one of the inputs 126 of the power source 106. In such examples, the knob would act as the actuator 132 and move a conductive target 134 along the length of the coils 136 and 138 as the knob is manipulated. The output of the LDC 142 would correspond to the position of the knob and could be used to control whichever function that the knob controls.

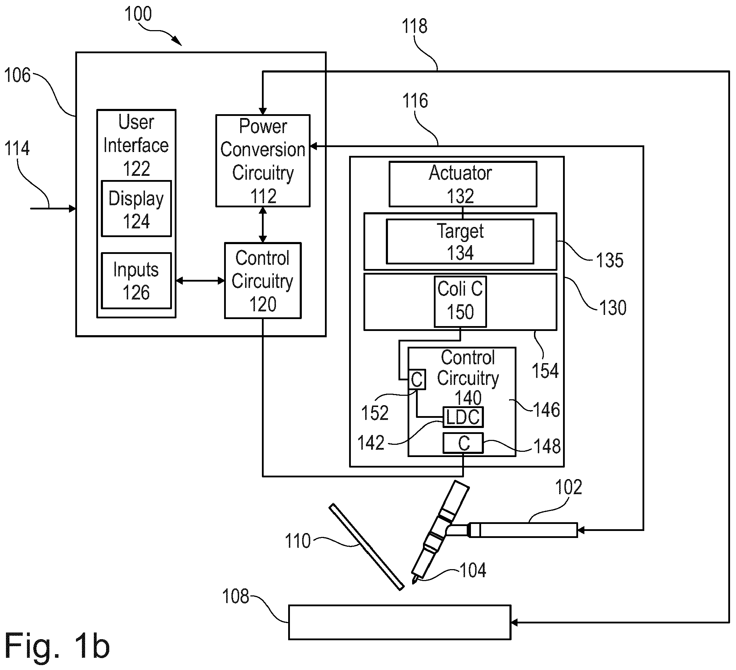

FIG. 1b is a diagram of an example gas tungsten arc welding ("GTAW") system 100 in which the physical control device 130 includes a single inductive coil, Coil C 150, and the accompanying sensor circuitry 152. Coil C 150 has a non-uniform spacing, and at rest, or at a neutral position, the target 134 is configured to be outside the length of the Coil C 150. Coil C 150 has a substantially flat geometric shape, meaning that Coil C 150 is generally contained within a plane. When the target 134 is outside the length of Coil C 150, then there are no lines that are perpendicular to the plane containing Coil C 150 that intersect both the target 134 and Coil C 150.

As the actuator 132 is moved, the target 134 enters and moves along the lengths of Coil C 150, which causes the resonant frequencies of the first resonator LC circuit (which includes coil C 150 and sensor circuitry C 152) to change. The LDC 142 detects the change in resonant frequency and provides digital outputs proportional (e.g., directly or inversely proportional) to the resonant frequency of the LC resonator circuit.

As described above, for a non-uniformly spaced, coil, the flux density gradient increases slowly from the sparsely wound end of the coil to the point where the sparse region transitions to a dense region, and then increases rapidly from the transition point to the dense end of the coil. Accordingly, the output of the LDC 142 for the resonant circuit including the non-uniformly spaced Coil C 150 will increase slowly as the target 134 enters the sparsely wound region until the target 134 reaches the transition point. The output of the resonant circuit will then decrease more rapidly as the target 134 moves from the point of transition point towards the dense end of Coil C 150. The actuator 132, target 134, and Coil C 150, are configured such that the target 134 is restricted from reaching the transition point. Thus, as the target 134 moves in one direction from the neutral (or rest point) outside the length of Coil C 150 to the restriction point, the output of the LDC 142 is monotonic (never decreasing).

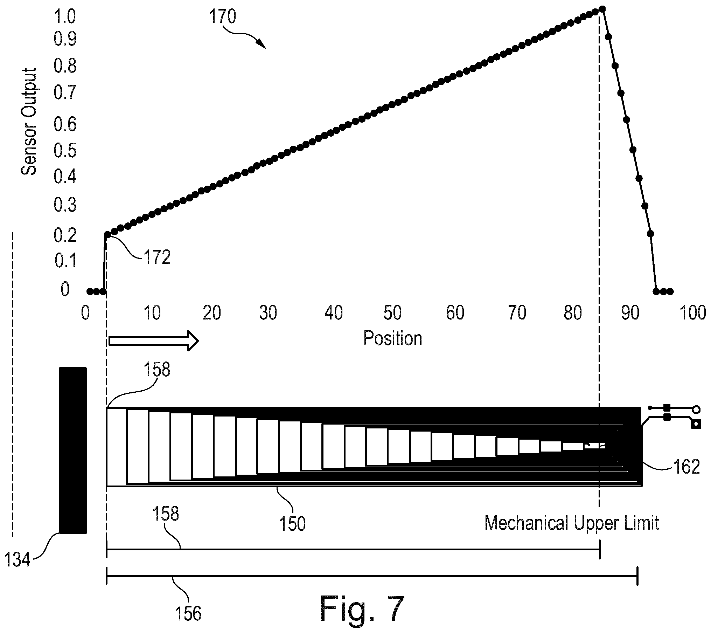

As explained in detail with respect to FIG. 7 below, as the target 134 enters the length of Coil C, the control circuitry 140 determines when the output of the LDC 142 reaches a threshold magnitude. When the output of the LDC 142 reaches the threshold magnitude, the communications circuitry 148 communicates an "on" signal to the control circuitry 120. Similarly, when the target 134 passes back outside of the length of the length of Coil C 150, the output of the LDC 142 falls below the threshold magnitude. The communications circuitry 148 then communicates an "off signal to the control circuitry 120. After the control circuitry 140 determines that the output of the LDC 142 satisfied the first threshold, the control circuitry 140 monitors the magnitude of the output of the LDC 142. The communications circuitry 148 sends a signal representative of the magnitude of the output of the LDC 142 to the control circuitry 120. Accordingly, after the threshold is satisfied, further actuation of the actuator 132 satisfies a potentiometer function.

To prevent error caused by movement in the z-axis, the target 134 and Coil C 150 are biased to maintain a consistence distance relative to each other in the z-axis. In some examples, the target 134 is printed onto a flexible printed circuit board 135, and coil C 150 is printed onto a rigid printed circuit board 154. In some examples, the flexible printed circuit board 135 is biased such that the flexible printed circuit board 135 maintains a consistent distance with the rigid printed circuit board 154.

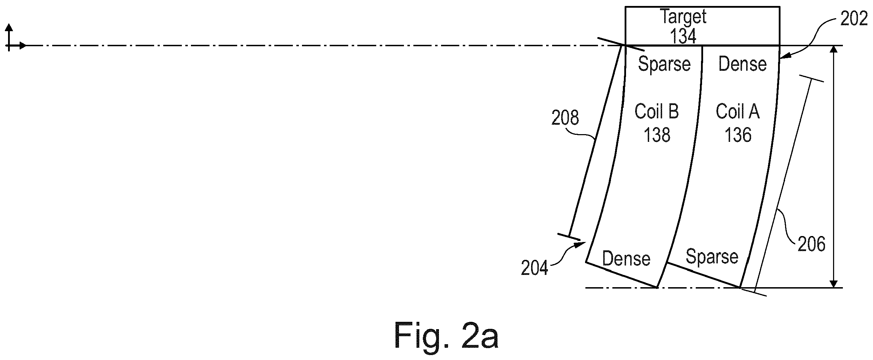

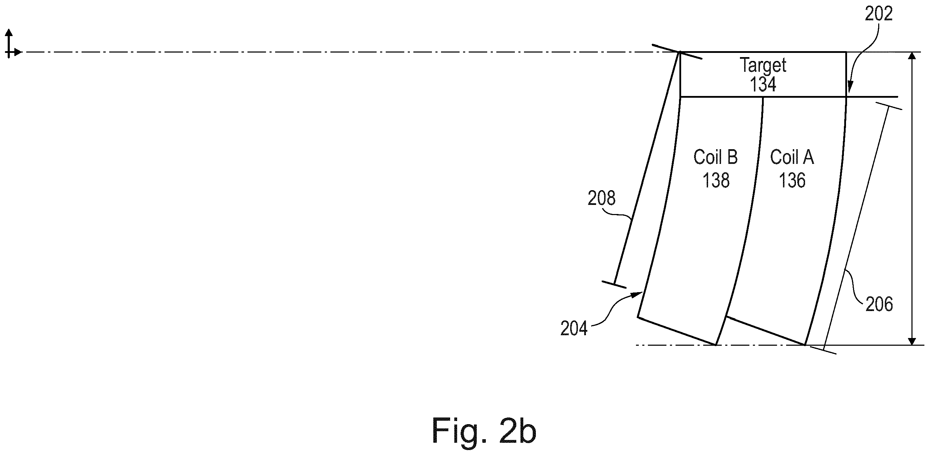

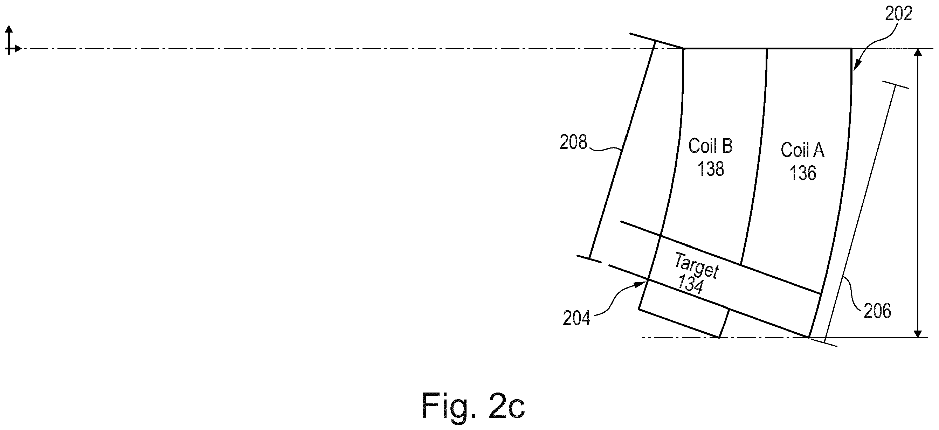

FIGS. 2a, 2b, and 2c are drawings of a target 134 sweeping across coil A 136 and coil B 138 as the target 134 is actuated in a physical control device 130. In FIGs 2a, 2b, and 2c, the physical control device 130 is a foot pedal, and the coils 136 and 138 are slightly arced because the physical path that the target 134 travels as the target 134 is actuated by the foot pedal is arc-shaped. As shown in FIG. 2a, the target 134 is at rest outside of the lengths of coil A 136 and coil B 138. Coil A 136 has a dense region and a sparse region, and the density of the coil A 136 decreases after the transition point 202. Coil B 138 also has a dense region and a sparse region, and a transition point 204.

In some examples, each of the coils 136, 138 incrementally or continually decreases in coil density from the transition point to the end of the sparse region within the monotonic region. In some examples, the spacing in the sparse region is consistent throughout the sparse region. Coil A 136 has a monotonic region 206 where the output of the LDC 142 for the circuit including coil A 136 will decrease as the target 134 moves from the transition point 202 to the sparse end of the coil. Coil B 138 has a monotonic region 208 where the output of the LDC 142 for the circuit including coil B 138 will increase as the target 134 moves from the sparse end of the coil to the transition point 204.

As shown in FIG. 2b, the target 134 enters from the dense region of coil A 136 and the sparse region of coil B 138. The output of the LDC 142 for the circuit including coil A 136 is used as a switch for welding-type power supplied from the power source 106 to the torch 102. As shown in FIG. 2c, the foot pedal is arranged such that the target 134 does not travel past the transition point 204 of coil B 138.

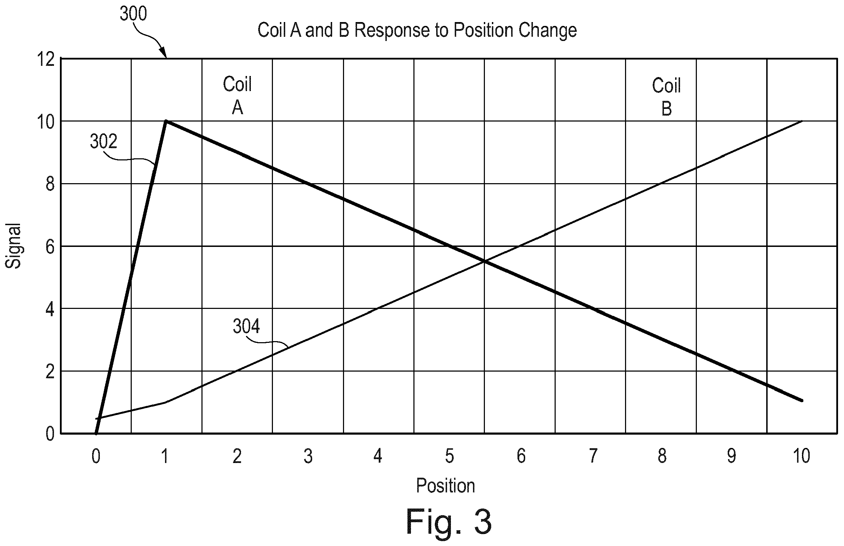

FIG. 3 is a graph 300 showing the outputs of the LDC 142 for each of circuits including coil A 136 and coil B 138 in response to the movement of the target 134 along the lengths of the coils, as shown in FIGS. 2a-2c. Line 302 shows an output of the LDC 142 for the circuit including coil A 136 as the target 134 moves along the length of coil A 136. Line 304 shows an output of the LDC 142 for the circuit including coil B 138 as the target 134 moves along the length of coil B 138. As the target 134 enters the lengths of the coils 136 and 138, the output for the circuit including coil A 136 will increase rapidly until the target reaches the transition point 202. After the target 134 passes the transition point 202, the output for the circuit including coil A 136 will decrease slowly. As the target 134 does not reach the transition point 204 for coil B 138, the output for the circuit including coil B 138 only increases. In some examples, in order to ensure that the target 134 never reaches the transition point 204 of coil B 138, the monotonic region 208 of coil B 138 is longer than the entire physical length of coil A 136.

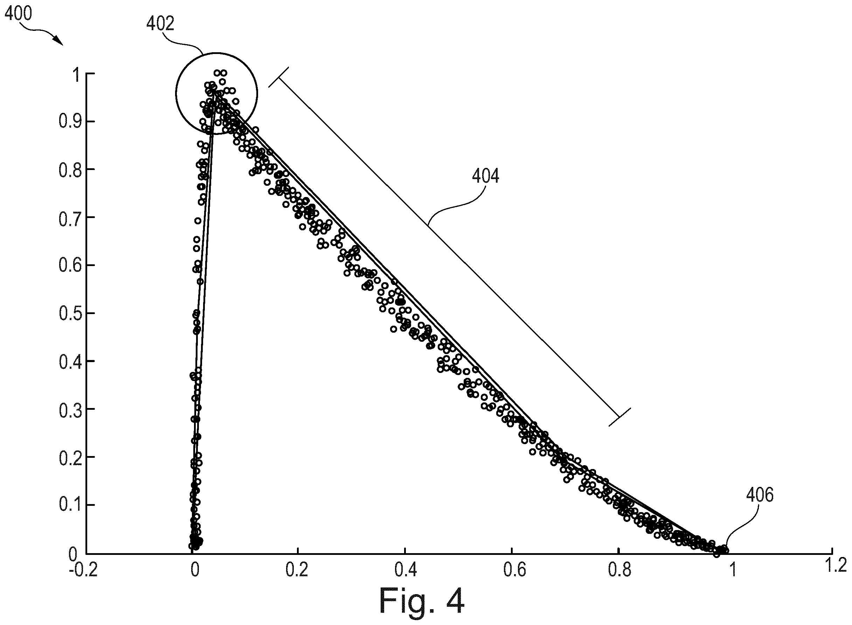

FIG. 4 is a plot 400 of experimental data showing the output of an LDC 142 for the circuit including coil A 136 on the y-axis and the output of the LDC 142 for the circuit including coil B 138 on the x-axis for the foot pedal of FIGS. 2a-2c. The control circuitry 140 may use the plot 400 to recognize actuation of the foot pedal and in response send signals to the control circuitry 120 of the power source 106 in order to control the power supplied by the power source 106. The knee point 402 occurs at the point where the target 134 passes the transition point 202 and enters the sparse region of coil A 136. After the target 134 passed the transition point 202, the outputs of the LDC 142 for the circuits including coil A 136 and coil B 138 are both monotonic. Accordingly, this portion 404 of the plot 400 is approximately linear and is used by the control circuitry 140 to control the magnitude of the power supplied by the power source 106 to the torch 102.

In some examples, the control circuitry 140 may recognize when a second threshold point is reached. For example, the output of the LDC 142 may occur at point 40 when the pedal is pressed to a maximum distance. The control circuitry 140 may recognize that the pedal has been pressed to the farthest point because the output of the LDC 142 is at point 406. In some examples, if the control circuitry 140 recognizes that the LDC 142 output has reached point 406, then the control circuitry 140 will communicate to the control circuitry 120 of the power source 106 to supply output power at a stable level (which may be for example the maximum set output power) until the control circuitry 140 determines that the pedal has been pressed to the farthest point again by determining for a second time that the LDC 142 output is at point 406. Accordingly, the control circuitry 140 may recognize a point on the LDC 142 output plot as a second switch in addition to the first switch at point 402. This second switch may be used for purposes such as triggering the control circuitry 140 to control the welding-type power source 106 to control the output power according to a predetermined set of parameters. For example, the second switch, when triggered, may cause the control circuitry 140 to signal to the control circuitry 120 to control the power conversion circuitry 112 to output a full power level configured via the user interface, to switch on an arc stabilizing circuit, and/or any other parameter and/or process configuration.

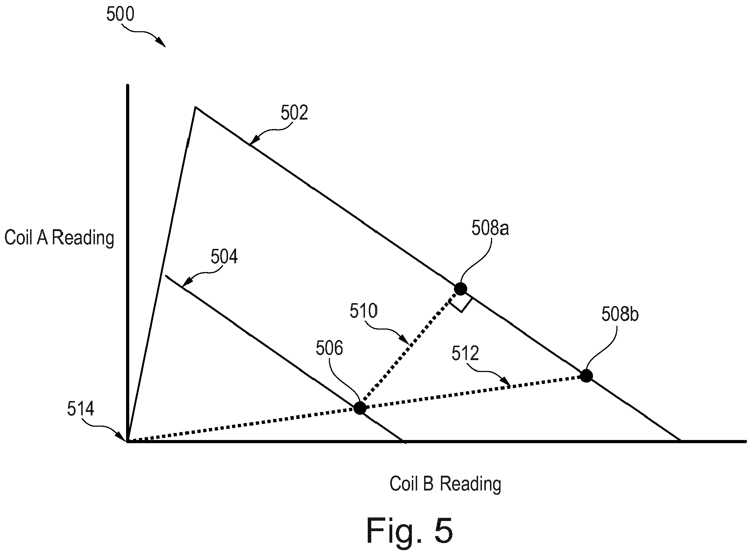

FIG. 5 is a plot 500 demonstrating the response to movement of the target 134 away from the plane of the coils. As with FIG. 4, the y-axis shows the output of the LDC 142 for the circuit including coil A 136, and the x-axis shows the output of the LDC 142 for the circuit including coil B 138. As explained above, coil A 136 and coil B 138 are positioned in the same plane (i.e., an x-y plane). The z-axis is perpendicular to the x-y plane. Under normal circumstances, the target 134 is a given distance in the z-axis from the x-y plane. In some examples, the target 134 is printed onto a flexible printed circuit board 135, and coil A 136 and coil B 138 are printed onto a rigid printed circuit board 137. In some examples, the flexible printed circuit board 135 is biased such that the flexible printed circuit board 135 maintains a consistent distance with the rigid printed circuit board 137. In such situations, the target 134 maintains the same distance from the x-y plane in the z-axis. Although described as the target being printed onto a flexible board and the coils on a rigid board, in some examples, the coils may be printed onto a flexible board biased to maintain a consistent distance from the target in the z-axis while the target is fixed in the x-y plane.

In real-world applications, the target 134 may move away from or closer to the x-y plane that includes coil A 136 and coil B 138. When the target 134 moves away from the coils in the z-axis, the output of the LDC 142 for the circuits including the coils decreases. If only one coil, for example coil A 136 is used, then if the target 134 moves away from the x-y plane in the z-axis, the output of the LCD 142 would decrease and the control circuitry 140 would determine that the output from the power source 106 should be decreased. In other words, movement of the target 134 away from the x-y plane in the z-axis appears to the LDC 142 like movement from the dense region to the sparse region of the coil. Thus, movement of the target 134 in the z-axis constitutes error. Using two coils eliminates that error.

Line 502 represents an example plot in which the target 134 does not move in the z-axis. Line 502 may be stored in memory of the control circuitry 140 as a reference line. Line 504 represents a plot in which the target 134 has moved away from the x-y plane in the z-axis. Since both coils 136 and 138 are affected by the same error (the movement away from the x-y axis), the control circuitry 140 recognizes the error by determining that the output from the LDC 142 is smaller than expected. The control circuitry 140 then compares an actual measured output (e.g., a point on the line 504) to the reference line 502 to correct for the error. The output line 504 when the target 134 moves in the z-axis away from the x-y plane has the same shape and output relationship as the reference output line 502 when the target 134 is closer in the z-axis, but is scaled (e.g., by 50%). The scale can be determined by the control circuitry 140, and all output data from the LDC 142 can be similarly scaled by the control circuitry 140 to eliminate any error caused by movement of the target 134 in the z-axis.

For example, the control circuitry 140 may recognize that output of the LDC 142 is at point 506. The control circuitry can then determine the scale between the point 506 and a corresponding point on reference line 502 to determine the scale between line 504 and reference line 502. In some examples, the control circuitry may find the line 510 which is perpendicular to line 502 and passes through point 506, where point 506 is the measured output of the LDC 142. The control circuitry 140 then determines the scale between lines 502 and 504 based on the scale between points 506 and 508a. The control circuitry 140 may then scale all other measured values based on the determined scale between points 506 and 508b to eliminate error caused by the movement of the target in the z-axis. In some examples the control circuitry may find the point 508b on reference line 502 which intersects with a line 512 that passes through point 506 and the origin 514. The control circuitry 140 may then determine the scale between lines 502 and 504 based on the scale between point 506 and 508b. The control circuitry 140 may then scale all other measured values based on the determined scale between points 506 and 508b to eliminate error caused by the movement of the target in the z-axis.

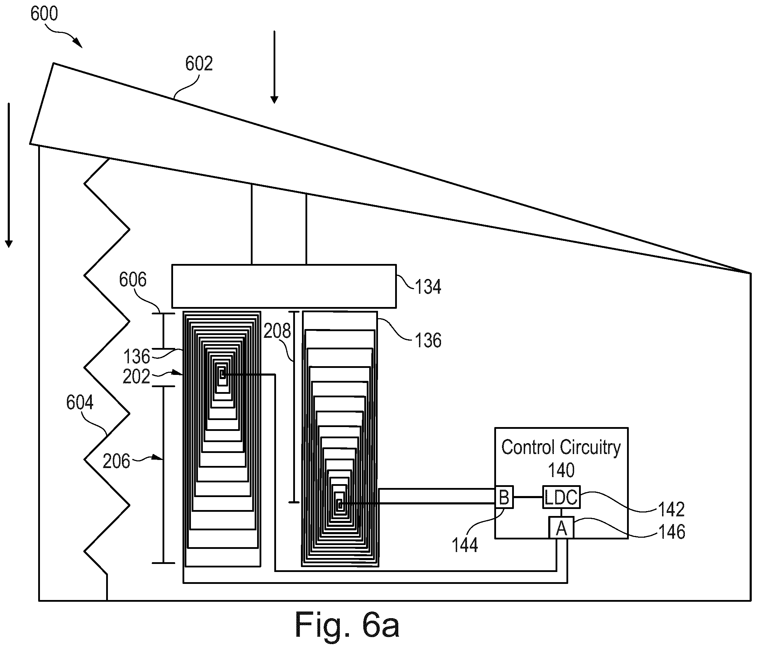

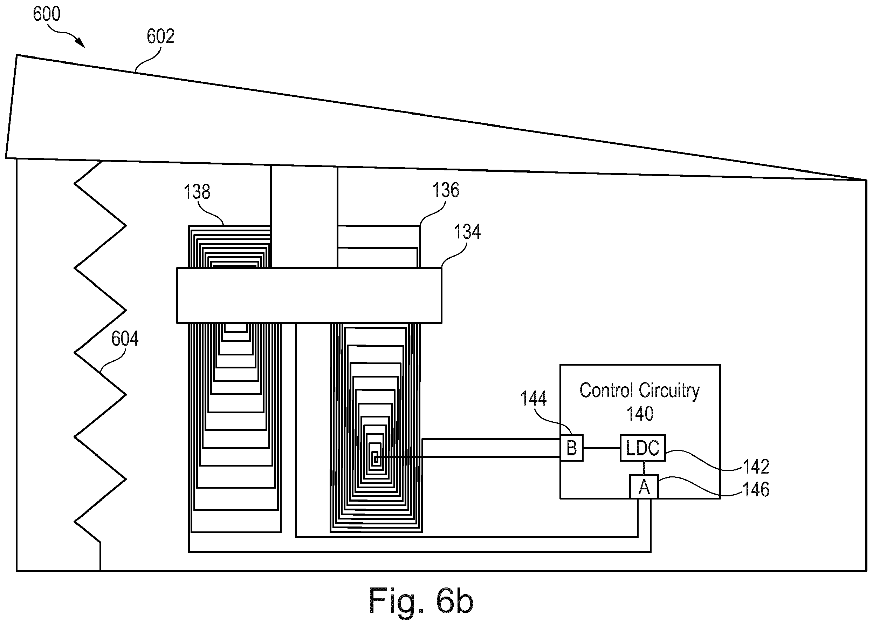

FIGS. 6a and 6b illustrate an example foot pedal 600 which may be used to control the output of a welding power source, for example the power source 106 of FIG. 1. The foot pedal 600 includes a coil A 136 and a coil B 138 as well as control circuity 140. The control circuitry 140 includes sensor circuitry A 144 and sensor circuitry B 146 as well as an LDC 142 to convert the response of the inductive circuits including the coils (coil A 136 and sensor circuitry A 144 constitute inductive circuit A and coil B 138 and sensor circuitry B 146 constitute inductive circuit B).

When an operator presses down on the panel 602 of the foot pedal 600, the conductive target 134 moves downwards and passes into the lengths of the coils (coil A 136 and coil B 138). A spring 604 is biased to push upwards against the panel 602 so that the panel 602 returns to its original position when the operator is not pressing down on the panel 602. In the original position (shown in FIG. 6a), the target 134 does not overlap the coils (coil A 136 and coil B 138). As the panel 602 is actuated, the target 134 moves downwards along the length of the coils (coil A 136 and coil B 138). The target 134 enters coil A 136 in the dense region 606 of coil A 136 and the monotonic region 208 of coil B 138 (shown in FIG. 6b). The output of the LDC 142 for circuit A increases rapidly as the target 134 enters the length of the coils until the target reaches the transition point 202. The transition point 202 is the point where the dense region 606 transitions to the sparse region 206. The output of the LDC 142 for circuit A then decreases slowly as the target 134 moves along the sparse region 206. The pedal 600 is configured such that the range of motion of the panel 602 ends within the monotonic region 208 of coil B 138. Thus, the output of the LDC 142 for the circuit B is increasing as the target 134 moves downwards (i.e., when the panel 602 is pressed down) and decreasing as the target 134 moves back up (i.e., when downward pressure on the panel 602 is released and the force from the spring 604 pushes the panel upwards).

The control circuitry 140 processes the outputs of the LDC 142 to determine when the output for circuit A exceeds a threshold. Whether the output for circuit A exceeds a threshold functions as a switch. The outputs of the LDC 142 for circuit A and circuit B after the point at which the target 134 passes the threshold is approximately linear, and thus can be used similarly to a potentiometer. Accordingly, the control circuitry 140 processes the output of the LDC 142 and sends signals to control circuitry 120 of the power source 106 based on the processed output of the LDC 142. The output of the LDC 142 is based on the position of the target 142, which is based on the position of the panel 602 of the foot pedal 600. Accordingly, an operator may control the output of the power source 106 by controlling the position of the foot pedal 600.

As illustrated in FIGS. 6a and 6b, coil A 136 and coil B 138 have non-uniform spacing, meaning that spacing between successive loops of the coils are not always equal. Coil A 136 and coil B 138 each have dense regions (regions with smaller coils spacing) and sparse regions (regions with greater coil spacing). Density refers to the amount of loops of the coil in a given distance, and is the inverse of the coil spacing. The sparse regions are region 206 for coil A 136 and region 208 for coil B 138.

FIG. 7 is a diagram of single coil application as described with reference to FIG. 1b as well as a plot 170 of the LDC output for the single coil application. At rest, the target 134 is outside the length 156 of Coil C 150. As the target 134 is actuated by the actuator 132 (FIG. 1b), the target 134 enters the length 156 of Coil C 150. As the target enters 134 the length of Coil C 150, the output of the LDC 142 increases quickly until it reaches the point 172. The magnitude at point 172 may be used as a predetermined threshold magnitude which is used as a switch function. If the magnitude of the LDC 142 output is below the known magnitude at point 172, then the switch is off. If the magnitude of the LDC 142 output is above the known magnitude at point 172, then the switch is on.

The target 134 is restricted such that within the length of Coil C 150 the target 134 only travels within the monotonic region 158. The actuator 132 (FIG. 1b) is mechanically configured such that the target does not reach the transition point 162 of Coil C 150. Accordingly as shown in the plot 170, for each position along the length 156 of Coil C 150 within the monotonic region, there is a single output value. The output value of the LDC 142 within the monotonic region 158 is used to control the output level, similarly to a potentiometer in a conventional switch/potentiometer device.

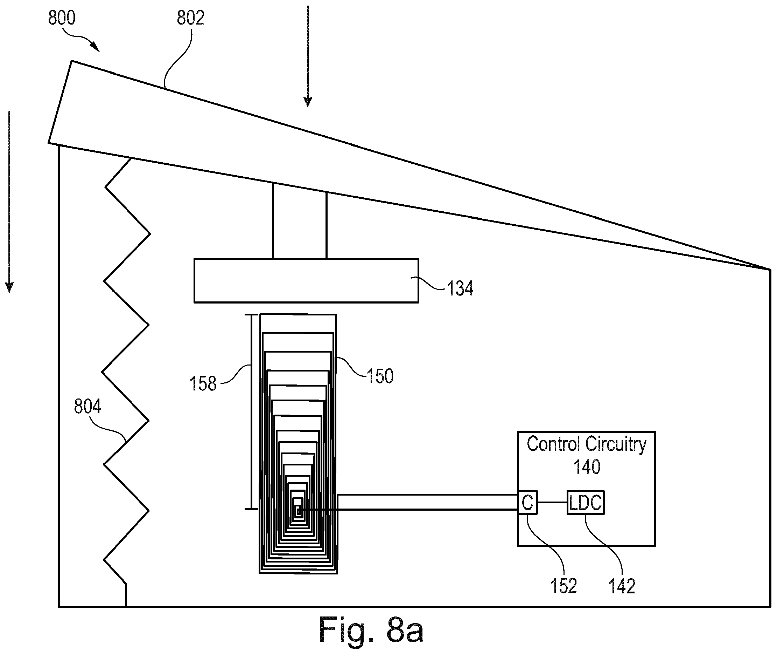

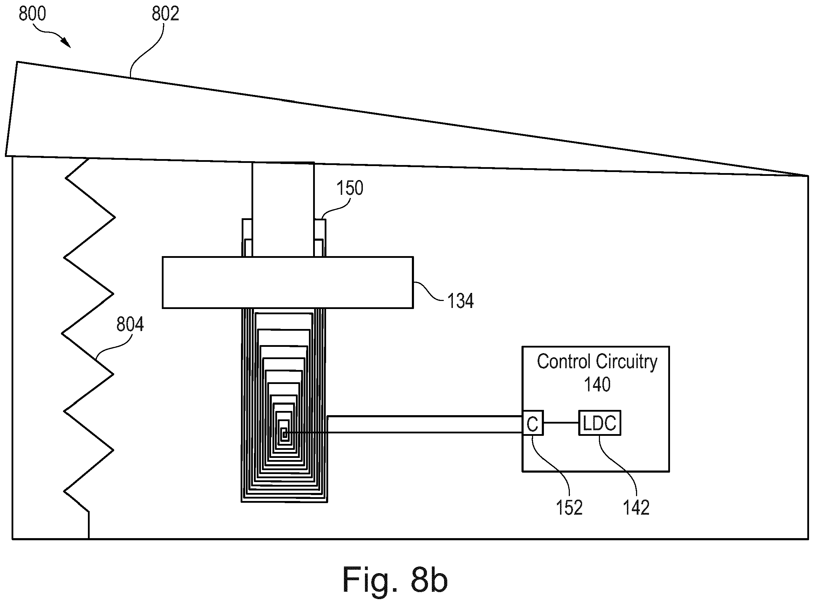

FIGS. 8a and 8b illustrate an example foot pedal 800 which may be used to control the output of a welding power source, for example the power source 106 of FIG. 1, where the foot pedal 800 includes a single coil, Coil C 150.

The control circuitry 140 includes sensor circuitry C 152 as well as an LDC 142 to convert the response of the inductive circuit including Coil C 150 (coil C 150 sensor circuitry C 152 constitute inductive circuit C).

When an operator presses down on the panel 802 of the foot pedal 800, the conductive target 134 moves downwards and passes into the length of coil C 150. A spring 804 is biased to push upwards against the panel 802 so that the panel 802 returns to its original position when the operator is not pressing down on the panel 602. In the original position (shown in FIG. 8a), the target 134 does not overlap coil C 150. As the panel 802 is actuated, the target 134 moves downwards along the length of coil C 150. The target 134 enters the monotonic region 158 of coil C 150 (shown in FIG. 8b). The pedal 800 is configured such that the range of motion of the panel 802 ends within the monotonic region 158 of Coil C 150. Thus, the output of the LDC 142 for the circuit C is increasing as the target 134 moves downwards (i.e., when the panel 802 is pressed down) and decreasing as the target 134 moves back up (i.e., when downward pressure on the panel 802 is released and the force from the spring 804 pushes the panel 802 upwards).

The control circuitry 140 processes the output of the LDC 142 to determine when the output for circuit C exceeds a threshold. Whether the output for circuit C exceeds a threshold functions as a switch. The threshold is selected such that the output of the LDC 142 exceeds the threshold when the target enters the length of coil C 150. The outputs of the LDC 142 for circuit C after the point at which the target 134 passes the threshold is approximately linear, and thus can be used similarly to a potentiometer. Accordingly, the control circuitry 140 processes the output of the LDC 142 and sends signals to control circuitry 120 of the power source 106 based on the processed output of the LDC 142. The output of the LDC 142 is based on the position of the target 142, which is based on the position of the panel 802 of the foot pedal 800. Accordingly, an operator may control the output of the power source 106 by controlling the position of the foot pedal 800.

Although generally described as controlling output power in TIG welding applications, the inductive sensors described may be used in any welding type application to control any welding parameter or used for the synergistic control of multiple parameters.

While the present method and/or system has been described with reference to certain implementations, it will be understood by those skilled in the art that various changes may be made and equivalents may be substituted without departing from the scope of the present method and/or system. For example, block and/or components of disclosed examples may be combined, divided, re-arranged, and/or otherwise modified. In addition, many modifications may be made to adapt a particular situation or material to the teachings of the present disclosure without departing from its scope. Therefore, the present method and/or system are not limited to the particular implementations disclosed. Instead, the present method and/or system will include all implementations falling within the scope of the appended claims, both literally and under the doctrine of equivalents.

Certain implementations are described in the following numbered clauses:
Clause 1. A sensor, comprising:
   a first coil having a spacing that increases along a length of the first coil from a first region having a first density to a second region having a second density lower than the first density;
   a second coil having a spacing that increases along a length of the second coil from a third region having a third density to a fourth region having a fourth density lower than the third density;
   a conductive target configured to travel along the length of the coils, wherein the first coil and the second coil are arranged such that the conductive target is adjacent the first region when the conductive target is adjacent the fourth region and the conductive target is adjacent the second region when the conductive target is adjacent the third region; and
   measurement circuitry configured to measure a first response of the first coil and a second response of the second coil.
Clause 2. The sensor of clause 1, wherein the first coil has a first monotonic region extending from a first end of the first coil having a low-density spacing to the first dense region,
and wherein the second coil has a second monotonic region extending from a second end of the second coil having a low-density spacing to the second dense region.
Clause 3. The sensor of clause 2, wherein the first monotonic region has a length greater than the length of the second coil.
Clause 4. The sensor of clause 2, wherein the target is configured to travel within the first monotonic region.
Clause 5. The sensor of clause 1, wherein the first response is a first inductance and the second response is a second inductance.
Clause 6. The sensor of clause 1, wherein the first coil is connected to a first resonant circuit and the second coil is connected to a second resonant circuit, and wherein the first response comprises a first resonant frequency of the first resonant circuit and the second response comprises a second resonant frequency of the second resonant circuit.
Clause 7. The sensor of clause 1, wherein the measurement circuitry is configured to:
   determine a position of the target relative to the first coil based on the first response and the second response; and
   determine whether the second response satisfies a threshold.
Clause 8. The sensor of clause 7, wherein the measurement circuitry is configured to:
   output a first signal indicating whether the second response satisfies the threshold, and
   output a second signal based on the position of the target if the second response satisfies the threshold.
Clause 9. The sensor of clause 1, wherein the first coil and the second coil are formed on a first circuit board, and wherein the target comprises a conductive strip printed on a second circuit board.
Clause 10. The sensor of clause 9, wherein the first circuit board is a rigid printed circuit board and the second circuit board is a flexible circuit board.
Clause 11. The sensor of clause 10, wherein the second circuit board is biased to maintain a constant distance between with the first circuit board and the second circuit board as the target travels along the length of the coils.
Clause 12. A mechanically actuated controller comprising:
   a first coil having a spacing that increases along a length of the first coil from a first region having a first density to a second region having a second density lower than the first density;
   a second coil having a spacing that increases along a length of the second coil from a third region having a third density to a fourth region having a fourth density lower than the third density;
   a mechanical travel device configured to actuate a conductive target, wherein the conductive target is configured to travel along the length of the coils, wherein the first coil and the second coil are arranged such that the conductive target is adjacent the first region when the conductive target is adjacent the fourth region and the conductive target is adjacent the second region when the conductive target is adjacent the third region; and
   measurement circuitry configured to measure a first response of the first coil and a second response of the second coil.
Clause 13. The controller of clause 12, wherein the mechanical travel device is a foot pedal.
Clause 14. The controller of clause 12, wherein the first coil has a first monotonic region extending from a first end of the first coil having a low-density spacing to the first dense region, and wherein the second coil has a second monotonic region extending from a second end of the second coil having a low-density spacing to the second dense region.
Clause 15. The controller of clause 14, wherein the first monotonic region has a length greater than the length of the second coil.
Clause 16. The controller of clause 14, wherein the target is configured to travel within the first monotonic region.
Clause 17. The controller of clause 14, wherein the first response is a first inductance and the second response is a second inductance.
Clause 18. The controller of clause 14, wherein the first coil is connected to a first resonant circuit and the second coil is connected to a second resonant circuit, and wherein the first response comprises a first resonant frequency of the first resonant circuit and the second response comprises a second resonant frequency of the second resonant circuit.
Clause 19. A welding control device comprising:
   a first coil having a spacing that increases along a length of the first coil from a first region having a first density to a second region having a second density lower than the first density;
   a second coil having a spacing that increases along a length of the second coil from a third region having a third density to a fourth region having a fourth density lower than the third density;
   a conductive target configured to travel along the length of the coils, wherein the first coil and the second coil are arranged such that the conductive target is adjacent the first region when the conductive target is adjacent the fourth region and the conductive target is adjacent the second region when the conductive target is adjacent the third region; and
   measurement circuitry configured to measure a first response of the first coil and a second response of the second coil; and
   communications circuitry configured to:
      communicate, to a welding device, an enable signal indicating whether to enable or disable a welding process based on whether the second response satisfies a threshold; and
      communicate, to the welding device, a control signal to control the welding process based in part on the first response and the second response if the second response satisfies the threshold.
Clause 20. The welding control device of clause 19, comprising a mechanical travel device configured to actuate the conductive target.

## Claims

1. A sensor, comprising:
a first coil having a spacing that increases along a length of the first coil from a first region having a first density to a second region having a second density lower than the first density;
a second coil having a spacing that increases along a length of the second coil from a third region having a third density to a fourth region having a fourth density lower than the third density;
a conductive target configured to travel along the length of the coils, wherein the first coil and the second coil are arranged such that the conductive target is adjacent the first region when the conductive target is adjacent the fourth region and the conductive target is adjacent the second region when the conductive target is adjacent the third region; and
measurement circuitry configured to measure a first response of the first coil and a second response of the second coil.

2. The sensor of claim 1, wherein the first response is a first inductance and the second response is a second inductance.

3. The sensor of claim 1, wherein the measurement circuitry is configured to:
determine a position of the target relative to the first coil based on the first response and the second response; and
determine whether the second response satisfies a threshold.

4. The sensor of claim 3, wherein the measurement circuitry is configured to:
output a first signal indicating whether the second response satisfies the threshold, and
output a second signal based on the position of the target if the second response satisfies the threshold.

5. The sensor of claim 1, wherein the first coil and the second coil are formed on a first circuit board, and wherein the target comprises a conductive strip printed on a second circuit board.

6. The sensor of claim 5, wherein the first circuit board is a rigid printed circuit board and the second circuit board is a flexible circuit board; and optionally wherein the second circuit board is biased to maintain a constant distance between with the first circuit board and the second circuit board as the target travels along the length of the coils.

7. A mechanically actuated controller comprising:
a first coil having a spacing that increases along a length of the first coil from a first region having a first density to a second region having a second density lower than the first density;
a second coil having a spacing that increases along a length of the second coil from a third region having a third density to a fourth region having a fourth density lower than the third density;
a mechanical travel device configured to actuate a conductive target, wherein the conductive target is configured to travel along the length of the coils, wherein the first coil and the second coil are arranged such that the conductive target is adjacent the first region when the conductive target is adjacent the fourth region and the conductive target is adjacent the second region when the conductive target is adjacent the third region; and
measurement circuitry configured to measure a first response of the first coil and a second response of the second coil.

8. The controller of claim 7, wherein the mechanical travel device is a foot pedal.

9. The sensor of claim 1, or the controller of claim 7, wherein the first coil has a first monotonic region extending from a first end of the first coil having a low-density spacing to the first dense region, and wherein the second coil has a second monotonic region extending from a second end of the second coil having a low-density spacing to the second dense region.

10. The sensor or controller of claim 9, wherein the first monotonic region has a length greater than the length of the second coil.

11. The sensor or controller of claim 9, wherein the target is configured to travel within the first monotonic region.

12. The sensor of claim 1, or the controller of claim 9, wherein the first response is a first inductance and the second response is a second inductance.

13. The sensor of claim 1, or the controller of claim 9, wherein the first coil is connected to a first resonant circuit and the second coil is connected to a second resonant circuit, and wherein the first response comprises a first resonant frequency of the first resonant circuit and the second response comprises a second resonant frequency of the second resonant circuit.

14. A welding control device comprising:
a first coil having a spacing that increases along a length of the first coil from a first region having a first density to a second region having a second density lower than the first density;
a second coil having a spacing that increases along a length of the second coil from a third region having a third density to a fourth region having a fourth density lower than the third density;
a conductive target configured to travel along the length of the coils, wherein the first coil and the second coil are arranged such that the conductive target is adjacent the first region when the conductive target is adjacent the fourth region and the conductive target is adjacent the second region when the conductive target is adjacent the third region; and
measurement circuitry configured to measure a first response of the first coil and a second response of the second coil; and
communications circuitry configured to:
communicate, to a welding device, an enable signal indicating whether to enable or disable a welding process based on whether the second response satisfies a threshold; and
communicate, to the welding device, a control signal to control the welding process based in part on the first response and the second response if the second response satisfies the threshold.

15. The welding control device of claim 14, comprising a mechanical travel device configured to actuate the conductive target.
